# EUROPÄISCHE PATENTSCHRIFT

(11) **EP 2 409 556 B1**
(45) Veröffentlichungstag und Bekanntmachung des Hinweises auf die Patenterteilung: **02.04.2014**
(21) Anmeldenummer: 10704796.1
(22) Anmeldetag: 09.02.2010
(51) Int. Cl.: H05K 13/00, H05K 13/08

(54) **VERFAHREN ZUR BESTIMMUNG VON RÜSTUNGEN FÜR KONSTANTE TISCHE VON BESTÜCKAUTOMATEN**
METHOD FOR DETERMINING FITTINGS FOR CONSTANT TABLES OF AUTOMATIC PLACEMENT MACHINES
PROCÉDÉ DE DÉTERMINATION D'ÉQUIPEMENTS POUR DES TABLES CONSTANTES DE MACHINES DE PLACEMENT AUTOMATIQUE

(30) Priorität: 16.03.2009 DE 102009013353
(43) Veröffentlichungstag der Anmeldung: 25.01.2012
(73) Patentinhaber: Siemens Aktiengesellschaft, 80333 München (DE)
(72) Erfinder: BAUER, Petra, 80797 München (DE); PFAFFINGER, Alexander, 81739 München (DE); ROYER, Christian, 85521 Ottobrunn (DE)
(86) Internationale Anmeldenummer: PCT/EP2010/051566
(87) Internationale Veröffentlichungsnummer: WO 2010/105876

(56) Entgegenhaltungen:
- EP-A2- 0 727 924
- US-B2- 6 829 514

## Beschreibung

Die Erfindung betrifft ein Verfahren zum Bestimmen von Rüstungen für konstante Tische von Bestückautomaten in Bestücklinien an fest vorgegebenen Tischlokationen, wobei die Rüstungen der konstante Tische in allen Rüstfamilien verwendet werden, wobei eine Rüstfamilie eine Menge von Losen umfasst, die innerhalb einer Rüstung gefertigt werden.

Weiterhin betrifft die Erfindung einen Bestückautomat, umfassend einen konstanten Tisch, dessen Rüstung durch das erfindungsgemäße Verfahren bestimmbar ist.

Mehrere Bestückautomaten, die üblicherweise durch ein Transportsystem verbunden sind, und die z.B. zum Fertigen von Elektronikteilen zusammenwirken, stellen eine Bestücklinie dar.

Bei Bestückautomaten z.B. zum Bestücken von Substraten mit Bauelementen sind seitlich an einer Transportstrecke für die Substrate Zuführvorrichtungen für Bauelemente angeordnet. Ein durch ein Positioniersystem verfahrbarer Bestückkopf des Bestückautomaten holt die Bauelemente von den Zuführvorrichtungen ab, verfährt diese zu einem Bestückbereich des Bestückautomaten, in dem das zu bestückende Substrat bereitgestellt ist, und setzt die Bauelemente auf dem Substrat ab. Für die Bereitstellung der Bauelemente werden z.B. sogenannte Gurt-Feeder eingesetzt, welche zum Transport und Zuführen von in Gurten gelagerten Bauteilen geeignet sind. Diese transportieren die in taschenartigen Vertiefungen magazinierten Bauteile zu einer Abholposition, an der die Bauteile von dem Bestückkopf aus den Gurttaschen abgeholt werden. Der leere Gurt verlässt die Zuführvorrichtung an einer geeigneten Stelle. Eine derartige Zuführvorrichtung ist aus der EP 1374657 B1 und US 6829514 bekannt.

Weiterhin ist es z.B. aus der Elektronikfertigung bekannt, die auf einer Bestücklinie zu fertigenden Lose in Rüstfamilien zusammenzufassen. Alle Lose einer Rüstfamilie werden jeweils mit derselben Linienrüstung gefertigt. Konstante Tische sind fest dabei aufgestellte und fest gerüstete Tische, die für alle Rüstungen der Rüstfamilien identisch sind. Das Konzept der konstanten Tische reduziert den Umrüstaufwand und ermöglicht es Rüstequipment einzusparen.

Heutzutage werden die Rüstungen der konstanten Tische durch einen Produktionsplaner jeweils mit einer individuellen Strategie basierend auf der Erfahrung des Produktionsplaners und mehr oder weniger durch Ausprobieren (trial-and-error) ermittelt. Der damit verbundene zeitliche Aufwand ist sehr hoch und die Ergebnisse sind oft nicht zufrieden stellend.

In der US Patentschrift US 6,829,514 B2 ist offenbart in Bestückungslinien eine Balancierungsstrategie auf Basis von Gemischt Ganzzahliger Linearer Programmierung (Mixed Integer Linear Programming, MILP) zu erhalten.

Die Aufgabe der vorliegenden Erfindung ist es, ein Verfahren zum Bestimmen von Rüstungen für konstante Tische von Bestückautomaten bereitzustellen, um einen optimalen Durchsatz mit möglichst wenigen Rüstfamilien zu erreichen.

Die Aufgabe wird mit einem Verfahren der eingangs genannten Art erfindungsgemäß gelöst dadurch dass die Rüstungen für die konstanten Tische mittels Gemischt Ganzzahliger Linearer Optimierung auf Basis von Eingabedaten und Eingabeparametern berechnet werden. Konstante Tische sind Fördertische von Produktions-, Fertigungs- oder Montagelinien, die bei einem Umrüstvorgang stehen bleiben können und nicht verändert werden müssen. Konstante Tische sind somit ein Beitrag zur Optimierung des Fertigungsprozesses, da sich Umrüstaufwände reduzieren und Rüstungsequipment eingespart werden kann. Auch reduziert sich der Raum- und Lagerbedarf, da weniger variable Tische vorgehalten werden müssen (unter einem variablen Tisch versteht man einen einer Stationsseite eines Bestückautomaten zugeordneten Wechsel- bzw. Fördertisch, bei dem die Rüstungen nicht für alle Rüstfamilien konstant sein müssen, sondern variieren, d.h. verändert werden können. Variable Tische müssen je nach Bedarf ausgetauscht werden.)

Wenn die Rüstungen für die konstanten Tische mittels Gemischt Ganzzahliger Linearer Optimierung (MILP) berechnet werden, können die Rüstungen zum einen schneller und zum anderen mit einer höheren Ergebnisqualität bestimmt werden. Ein Produktionsplaner muss somit nicht die Rüstungen für konstante Tische manuell (basierend auf seiner Erfahrung) oder mit einfachen Tabellenkalkulationsprogrammen (z.B. Excel) berechnen, was in der Regel durch Ausprobieren (trial and error) und unter einem großen Zeitaufwand erfolgt. Die mathematische Berechnung und Optimierung auf Grundlage Gemischt Ganzzahliger Linearer Optimierung (MILP) für Rüstungen konstanter Tische liefert bessere und schnellere Ergebnisse für den Produktionsplaner.

Eine erste vorteilhafte Ausgestaltung der Erfindung besteht darin, dass als Eingabedaten für die Berechnung der Rüstungen folgende, die Bestückinfrastruktur beschreibende, Daten verwendet werden:
- Tische mit Anzahl freier Spuren,
- Lokationen der konstanten Tische,
- Bauelemente mit Bestückpositionszahlen,
- Maximale Rüstanzahlen pro Bauelement,
- Mögliche Zuordnungen von Bauelementen zu Tischen,
- Spurbedarfe der Bauelemente auf den Tischen,
- Taktzeiten und Bestückpositionszahlen pro Bestückkopf im Ergebnis ermittelt aus einer Einzellosoptimierung.
Dadurch kann die durch Gemischt Ganzzahlige Lineare Optimierung zu berechnende Rüstung der konstanten Tische auf eine bestehende Bestückinfrastruktur hin dediziert optimiert werden, da alle vorliegenden Infrastrukturparameter bei der Berechnung berücksichtigt werden.

Eine weitere vorteilhafte Ausgestaltung der Erfindung besteht darin, dass als weiteres, die Bestückinfrastruktur beschreibendes, Eingabedatum für die Berechnung der Rüstungen eine minimale Taktzeitschranke vorgegeben wird. Dieses Eingabedatum erlaubt es, zu berücksichtigen, dass eine bestimmte Taktzeit nicht unterboten werden kann (z.B. die Ofenzeit).

Eine weitere vorteilhafte Ausgestaltung der Erfindung besteht darin, dass als vom Benutzer vorgebbare Eingabeparameter für die Steuerung der Bestückung folgende Parameter verwendet werden:
- der maximale Füllgrad für die konstanten Tische;
- der maximale Füllgrad für variable Tische;
- maximale Anzahl erlaubter Erhöhungen der MaxSetupCounts;
- Optimierungsstrategie eines Bedieners.
Durch diese Eingabeparameter kann das Bestückverfahren, wie es schließlich im Betrieb zum Ablauf kommt, durch den Benutzer gezielt beeinflusst werden. Der Benutzer kann z.B. durch die zu verwendende Optimierungsstrategie angeben, ob als Zielfunktion mehr Gewicht auf die Minimierung der Clusterzahl (d.h. der Rüstfamilien) oder ob als Zielfunktion mehr Gewicht auf die Minimierung der Gesamtproduktionszeit (Durchlaufzeit) gelegt werden soll. Dadurch ergibt sich eine hohe, vom Benutzer gezielt beeinflussbare, Flexibilität hinsichtlich des Produktionsprozesses.

Eine weitere vorteilhafte Ausgestaltung der Erfindung besteht in der Ausführung des Verfahrensschrittes:
Bestimmen von Rüstfamilien basierend auf den berechneten Rüstungen für die konstanten Tische. Basierend auf den durch die Gemischt Ganzzahlige Lineare Optimierung erhaltenen Rüstungen der konstanten Tische werden Rüstfamilien bestimmt, die die zu fertigenden Lose enthalten, die unter Verwendung der konstanten Tische zu produzieren sind. Die konstanten Tische müssen so gerüstet sein, dass alle vorgegebenen Boards (Leiterplatten) damit produzierbar sind. Geht dies nicht (was z.B. aus Kapazitätsgründen durchaus der Fall sein kann), so erfolgt eine Fehlermeldung.
Dadurch erfolgt eine weitere Optimierung der Produktion. Die Rüstung der konstanten Tische kann z.B. darauf abzielen, dass möglichst wenige Rüstfamilien gefunden werden.

Eine weitere vorteilhafte Ausgestaltung der Erfindung besteht in der Ausführung des Verfahrensschrittes:
Bestimmen der Rüstungen für die restlichen Tische in der Bestücklinie pro Rüstfamilie. Dadurch werden die Rüstungen für die restlichen variablen Tische einer Produktionslinie bestimmt. Es ist somit eine gesamtheitliche Optimierung einer Produktionslinie möglich.

Eine weitere vorteilhafte Ausgestaltung der Erfindung besteht in einem Computerprogramm-Produkt bzw. einem computerlesbaren Medium, welches auf einer programmgesteuerten Einrichtung (z.B. Computer oder Industrie-PC) die Durchführung des oben beschriebenen erfindungsgemäßen Verfahrens veranlasst. Dadurch ist das erfindungsgemäße Verfahren computerunterstützt ausführbar und als Produkt z.B. als Programm auf einer CD, DVD oder einem anderen Speichermedium (z.B. USB-Stick) vertreibbar.

Die Aufgabe wird weiterhin gelöst durch einen Bestückautomat, umfassend einen konstanten Tisch, wobei der Standort des konstanten Tisches in einer Bestücklinie vorgegeben ist, wobei die Rüstungen des konstanten Tisches in allen Rüstfamilien der Bestücklinie verwendet werden, wobei eine Rüstfamilie eine Menge von Losen umfasst, die innerhalb derselben Rüstung gefertigt werden, wobei.die Rüstungen für den konstanten Tisch gemäß einem Verfahren nach den Ansprüchen 1 bis 5 bestimmt sind. Bestückautomaten, die konstante Tische mit Rüstungen nach dem vorher beschriebenen Verfahren umfassen, sind in Produktionslinien verwendbar, z.B. zur Einsparung von Umrüstungen.

Ein Ausführungsbeispiel der Erfindung ist in der Zeichnung dargestellt und wird im Folgenden erläutert.

Dabei zeigen:

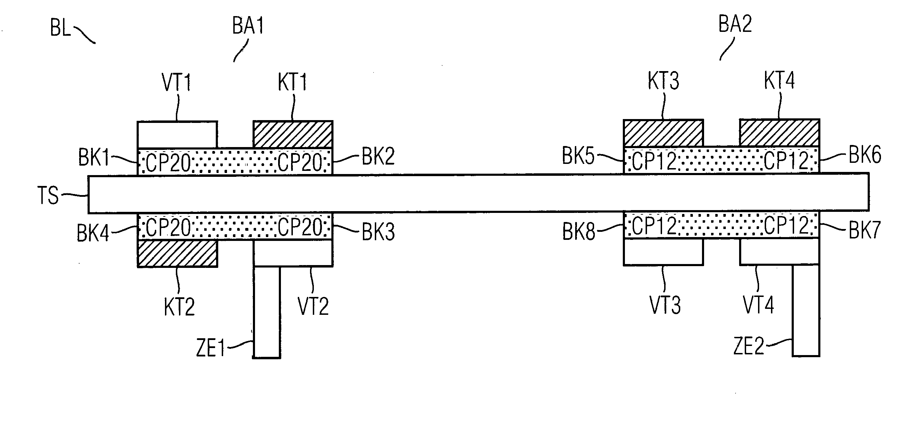

- FIG 1: eine beispielhafte Ausgestaltung einer Bestückungslinie mit zwei Bestückautomaten.

Fig.1 zeigt eine beispielhafte Ausgestaltung einer Bestückungslinie BL mit zwei Bestückautomaten BA1 und BA2, die an einem Transportsystem TS (z.B. Förderband) angeordnet sind.

Der Bestückautomat BA1 besteht aus vier Fördertischen KT1,KT2,VT1,VT2 von denen zwei variable Tische VT1,VT2 und zwei konstante Tische KT1,KT2 sind. Weiterhin besteht der Bestückautomat BA1 aus vier Bestückköpfen BK1-BK4 jeweils vom Typ CP20®. Die Bestückköpfe BK1-BK8 eines Bestückautomaten BA1, BA2 holen die Bauelemente von den Zuführvorrichtungen ZE1,ZE2 ab und verfahren diese zu einem Bestückbereich des Bestückautomaten BA1,BA2, wo das zu bestückende Substrat (z.B. eine Grundplatte bei SMD Fertigung) bereitgestellt ist, und setzt die Bauelemente auf dem Substrat ab. Die Bestückköpfe BK1-BK8 sind üblicherweise durch ein Positioniersystem verfahrbar. Als Zuführvorrichtungen ZE1,ZE2 für die Bereitstellung der Bauelemente können z.B. sogenannte Gurt-Feeder eingesetzt werden.

Ebenfalls am Transportsystem TS, welches die Grundplatte bereitstellt, angeordnet ist der Bestückautomat BA2 mit zwei variable Tischen VT3,VT4 und zwei konstanten Tischen KT3,KT4. Weiterhin besteht der Bestückautomat BA2 aus vier Bestückköpfen BK5-BK8 jeweils vom Typ CP12®.

In Figur 1 ist beispielhaft dargestellt, dass die variablen Tische VT2 und VT4 Zuführvorrichtungen ZE1 bzw. ZE2 aufweisen, zum Bereitstellen der zu bestückenden Bauelemente (z.B. Chips, Transistoren etc.).

In der SMD Fertigung (z.B. für elektronische Komponenten) werden für die Bestückung von Leiterplatten (Substrat) Bestückautomaten BA1,BA2 verwendet, die Bauelemente aus Zuführvorrichtungen ZE1,ZE2 mit Hilfe eines Bestückkopfes BK1-BK8 auf die Leiterplatten setzen. Die Leiterplatten (Boards) werden an den Bestückautomaten BA1,BA2 durch das Transportsystem TS bereitgestellt.

Üblicherweise (z.B. In der Elektronikfertigung) werden die auf einer Bestücklinie zu fertigenden Lose in Rüstfamilien zusammengefasst. Alle Lose einer Rüstfamilie werden jeweils mit derselben Linienrüstung gefertigt.

Konstante Tische KT1-KT4 sind fest aufgestellte und fest gerüstete Tische, die für alle Rüstungen der Rüstfamilien (Cluster) identisch sind. Damit lässt sich Umrüstaufwand reduzieren und Rüstequipment einsparen.

Unter einem konstanten Tisch KT1-KT4 versteht man somit einen einer Stationsseite eines Bestückautomaten (Location) zugeordneten Wechsel- bzw. Fördertisch, der einer Bestücklinie und einer Menge B von Losen (Recipes) mit zugehörigen Stückzahlen zugeordnet ist und dessen Rüstung für alle Cluster (d.h. Rüstfamilien), die nur Lose aus B enthalten, dieselbe ist. Für Rüstungen der konstanten Tische werden bevorzugt Bauelemente gewählt, die in vielen Losen benötigt werden.

Unter einem variablen Tisch VT1-VT4 versteht man einen einer Stationsseite eines Bestückautomaten zugeordneten Wechsel- bzw. Fördertisch, bei dem die Rüstungen nicht für alle Rüstfamilien konstant sein müssen, sondern variieren, d.h. verändert werden können. Variable Tische VT1-VT4 müssen je nach Bedarf ausgetauscht werden. Dies bedeutet Umrüstaufwand. Weiterhin müssen variable Tische VT1-VT4 zum Wechseln bereitgehalten werden, dies verursacht einen hohen Bedarf an Lagerraum.

Ein typisches Szenario (Use-Case) in Zusammenhang mit konstanten Tischen KT1-KT4 ist es, für eine gegebene Bestücklinie, eine Menge von Losen (Recipes) mit zugehörigen Stückzahlen und eine gegebene Menge von konstanten Tischen KT1-KT4, die Rüstungen der konstanten Tische KT1-KT4, eine Clusterung der gegebenen Boardtypenmenge sowie die zugehörigen Clusterrüstungen zu bestimmen. Dabei werden die Rüstungen der konstanten Tische KT1-KT4 bei der Bildung der Cluster und deren Rüstungen berücksichtigt.

Aufgabe des erfindungsgemäßen Verfahrens ist es, die Rüstungen für die konstanten Tische KT1-KT4 zu berechnen. Ziel ist dabei, diese Rüstungen so zu bestimmen, dass durch die nachgeschalteten Verfahrensschritte gute Ergebnisse hinsichtlich der Clusterzahl für die gegebene Losmenge bzw. hinsichtlich der Produktionszeiten erreicht werden.

### Mathematischer Hintergrund

Das Verfahren zur Bestimmung der Rüstungen für die konstanten Tische KT1-KT4 basiert auf der mathematischen Methode der Ganzzahligen Linearen Optimierung (Integer Linear Programming) bzw. der Gemischt Ganzzahligen Linearen Optimierung (Mixed Integer Linear Programming, MILP). In der Ganzzahligen Linearen Optimierung werden die zulässigen Lösungen des zu Grunde liegenden Problems durch eine Menge Variablen (ganzzahlig oder kontinuierlich) beschrieben, die einer Menge linearer Ungleichungen und Gleichungen genügen. Das Zielkriterium wird ebenfalls durch einen linearen Ausdruck formuliert, der zu maximieren oder zu minimieren ist.

Die Lineare Optimierung ist eines der Hauptverfahren auf dem Gebiet mathematische Optimierung und befasst sich mit der Optimierung linearer Zielfunktionen über einer Menge, die durch lineare Gleichungen und Ungleichungen eingeschränkt ist. Sie ist Grundlage der Lösungsverfahren der (gemischt-) ganzzahligen linearen Optimierung.

Ein Solver (vorteilhaft als Computerprogramm realisiert) für Ganzzahlige Lineare Optimierungsprobleme berechnet unter allen zulässigen Variablenbelegungen eine im Sinne der Zielfunktion optimale Belegung.

Die Ganzzahlige Lineare Optimierung stellt einen globalen Optimierungsansatz dar, die Modelle sind leicht anpassbar und es existieren sehr gute Standard-Solver (z.B. kommerzielle Computerprogramme wie Cplex® oder Xpress®), die sich in vielen praktischen Anwendungen bewährt haben.

Weitere Vorteile der Ganzzahligen Linearen Optimierung:
■ Globaler Optimierungsansatz
■ Leicht erweiterbar
■ Für eine ermittelte Lösung ist bekannt, wie weit sie maximal von der optimalen Lösung entfernt ist.

### Modell

Das erfindungsgemäße Verfahren besitzt mehrere Zielkriterien, die darauf abzielen die konstanten Tische KT1-KT4 so zu rüsten, dass nachgeordnete darauf aufbauende Verfahren
- Zielkriterium 1: eine Lösung mit möglichst wenig Rüstfamilien finden (Bestimmen der Clusteranzahl (Anzahl der Rüstfamilien) bei gegebenen konstanten Tischen), bzw.
- Zielkriterium 2: beim Line Balancing aller Tische (Bestimmen von Rüstungen für jedes Cluster (Rüstfamilie) für die übrigen Tische sowie Bestimmen der Taktzeiten der Lose) möglichst gute Produktionszeiten erreichen.

Die einzelnen Zielkriterien werden gewichtet und linear kombiniert. Dabei können Zielkriterium 1 bzw. 2 nur näherungsweise berücksichtigt werden: z.B. wird eine untere Schranke an die zu erwartende Clusterzahl minimiert und es wird versucht, auf den konstanten Tischen KT1-KT4 auch Bauteile unterzubringen, die mehrfach aufgestellt werden dürfen, um so dem Line Balancer Flexibilität zu gewähren.

Die Verfahren für das Bestimmen einer minimalen Clusteranzahl (Zielkriterium 1) bzw. für das Line Balancing aller Tische, um gute Produktionszeiten zu erreichen (Zielkriterium 2) erfolgt vorteilhafterweise durch Computerprogramme.

Optional kann unmittelbar nach dem Bestimmen der Rüstungen für die konstanten Tische KT1-KT4 ein Line Balancing für die erhaltenen konstanten Tische durchgeführt werden. Dadurch wird das Setup für die konstanten Tische KT1-KT4 optimiert, die Schritte für Zielkriterium 1 bzw. Zielkriterium 2 können somit genauer und schneller ausgeführt werden. Für Zielkriterium 2 ist eine höhere Qualität der Lösung (Produktionszeit) zu erwarten.

Die wichtigsten durch die linearen Gleichungen und Ungleichungen sowie die Ganzzahligkeitsbedingungen modellierten Restriktionen sind die folgenden:
1. Die vorgegebenen Kapazitäten der konstanten Tische KT1-KT4 werden eingehalten.
2. Es müssen für die Minimalcluster und für alle nicht in den Minimalclustern enthaltenen Lose unter Berücksichtigung der Rüstungen der konstanten Tische Rüstungen machbar sein.
3. Für jeden konstanten Tisch KT1-KT4 ergibt sich aus den dort aufgestellten Bauteilen, unter Berücksichtigung potentieller Mehrfachaufstellungen, eine Maximalzahl und eine Minimalzahl von dort bestückter Bauteile. Die sich daraus ergebenden approximierten Produktionszeiten dürfen nicht zu weit von der Produktionszeit im Einzellosfall abweichen (Schranke).
4. Die Zahl der potentiellen Mehrfachaufstellungen soll nicht zu groß werden (Schranke).

Es können im Zuge der Entwicklungen noch Anpassungen des Modells erforderlich werden.
Im Modell wird bei der Zuordnung von Bauelementen zu Tischen der Bestücklinie davon ausgegangen, dass konstante Tische einfache Kapazität und variable Tische unendliche Kapazität besitzen.

### Input (Eingabe)

Das Verfahren zum Bestimmen von Rüstungen für konstante Tische KT1-KT4 nimmt Eingabedaten (zur Beschreibung der zugrundeliegenden Infrastruktur) und Eingabeparameter (dienen der Steuerung des Verfahrens) entgegen.

Eingabedaten für das Verfahren sind:
- Linienbeschreibung (Automaten, Köpfe, Tische, festgerüstete Bauteile),
- Menge der konstante Tische,
- Menge aller Lose inklusive Losgrößen,
- Menge der Bauteiltypen (zulässige Köpfe, Spurbreite, MaxSetupCount),
- Menge der Minimalcluster,
- eine untere Taktzeitschranke (Taktzeit, etwa die Ofentaktzeit, die ohnehin nicht unterschritten werden kann),
- für jeden Kopf und jedes Los die Fixzeit,
- für jedes Los bzw. Minimalcluster die Gesamtproduktionszeit bei Einzellosoptimierung,
- für jedes Los bzw. Minimalcluster und jeden Kopf die Bestückzeit bei Einzellosoptimierung,
- für jedes Los bzw. Minimalcluster und jeden Kopf die Zahl der von diesem Kopf gesetzten Bestückpositionen bei Einzellosoptimierung.

Die Eingabeparameter, mit denen das Verfahren durch den Benutzer beeinflusst werden kann, sind:
- der maximale Füllgrad für die konstanten Tische KT1-KT4,
- der maximale Füllgrad für die variablen Tische VT1-VT4,
- maximale Anzahl erlaubter Erhöhungen der MaxSetupCounts,
- Strategie für das Verfahren (Algorithmic Strategy): Angabe des Bedieners, ob in der Zielfunktion mehr Gewicht auf die Flexibilität des Line Balancings (und damit auf niedrigere Produktionszeiten) oder auf die Minimierung der Clusterzahl gelegt werden soll. Mögliche Werte:
   a) mehr Gewicht auf der Minimierung der Clusterzahl,
   b) ausgewogene Verteilung des Schwerpunkts der Optimierung auf Clusterzahl und Gesamtproduktionszeit,
   c) mehr Gewicht auf der Minimierung der Gesamtproduktionszeit.
- minimale Taktzeit:
   dieser Parameter erlaubt es, zu berücksichtigen, dass eine bestimmte Taktzeit nicht unterboten werden kann (z.B. die Ofenzeit),
- Zeit, die der Linebalancer pro Los für die Balancierung innerhalb der konstanten Tische KT1-KT4 aufwendet (s. Zielkriterium 2).

Beim Verfahren zum Bestimmen von Rüstungen für konstante Tische haben sich folgende Default-Werte für die Eingabeparameter als vorteilhaft erwiesen:
- Maximaler Füllgrad für die variablen Tische: 95%,
- Maximaler Füllgrad für die konstanten Tische: 100%, (evtl. niedriger, falls der Benutzer nach dem Bestimmen der Rüstungen für die konstanten Tische ein Line Balancing für die erhaltenen konstanten Tische durchgeführt),
- Algorithmic Strategy: Ausgewogene Verteilung des Schwerpunkts der Optimierung auf Clusterzahl und Gesamtproduktionszeit,
- minimale Taktzeit: 0s,
- Zeit, die der Linebalancer pro Los für die Balancierung innerhalb der konstanten Tische aufwendet: 1 min (eine Minute).

Je geringer der maximal zugelassene Füllgrad für die konstanten bzw. die variablen Tische ist, desto mehr Cluster entstehen tendenziell (wobei natürlich je nach Datenlage moderate Verringerungen des maximal zulässigen Füllgrades nicht direkt zu einer Erhöhung der Clusterzahl führen müssen). Mehr Cluster führen tendenziell zu mehr Flexibilität des Linebalancers und damit zu geringeren Bestückzeiten.

Wird keine Optimierung innerhalb der konstanten Tische KT1-KT4 vorgenommen (optionaler Schritt nach dem Bestimmen der Rüstungen für die konstanten Tische), so ist der Vorteil einer Einschränkung des Füllgrades der konstanten Tische für den Kunden nur in einer größeren Flexibilität beim Einfügen später neu hinzukommender Produkte zu sehen. Wird innerhalb der konstanten Tische optimiert, so kann die gewonnene Flexibilität für den Linebalancer von Vorteil sein.

In manchen Situationen kann es für die Erreichung guter Produktionszeiten erforderlich sein, einzelne Bauteiltypen öfter aufzustellen, als durch MaxSetupCount vom Benutzer (Kunden) zugelassen. Ist der Kunde damit einverstanden, dass in Einzelfällen der MaxSetupCount durch das erfindungsgemäße Verfahren erhöht werden kann, so kann er vorgeben, wie oft das maximal geschehen darf. Durch Eingabe des Wertes "0" kann die Erhöhung von MaxSetupCounts generell verhindert werden. (Das erfindungsgemäße Verfahren minimiert die Anzahl der Erhöhungen, überschreitet die MaxSetupCounts also nicht öfter als notwendig.)

Die Zielfunktion des erfindungsgemäßen Verfahrens ist multikriteriell (siehe Zielkriterium 1, Zielkriterium 2). Die einzelnen Kriterien werden mit Gewichten versehen, auf die der Kunde in eingeschränktem Maße durch die Eingabeparameter Einfluss nehmen kann.

### Output (Ausgabe)

Das erfindungsgemäße Verfahren liefert
- für jeden der konstanten Tische die Menge der ihm zugeordneten Bauteiltypen,
- eine Menge von Bauteiltypen, für die jeweils der MaxSetupCount erhöht werden sollte,
- Fehlermeldungen, falls gegeben.

### Performance (Leistung)

Die Ganzzahlige Lineare Optimierung dient in erster Linie der Lösung kombinatorischer Optimierungsprobleme, die zur Klasse der NP-schweren Probleme gehören, zu denen auch das vorliegende Problem der Rüstungsbestimmung für die konstanten Tische KT1-KT4 gehört. Zufriedenstellende, verlässliche Laufzeitangaben können aus theoretischer Sicht für NP-schwere Probleme nicht gemacht werden.

Die Laufzeit des Verfahrens hängt im Wesentlichen von der Anzahl der möglichen Zuordnungen von Bauteiltypen zu konstanten Tischen KT1-KT4 ab (Größenordnung der Variablenzahl), jedoch auch von der konkreten Problemstruktur. Aus praktischer Sicht zeigen die bislang gemachten Erfahrungen bei der Optimierung der Rüstungen konstanter Tische KT1-KT4 für unterschiedliche Werke, dass das Verfahren in der Regel schnell und zuverlässig arbeitet. Lösungen für Instanzen, deren Größenordnung und Struktur im zu erwartenden Rahmen liegen. Beim einem Beispiel aus einem der Projekte (ca. 1300 Bauteiltypen, 5 konstante Tische) betrug die Laufzeit für das Verfahren, implementiert durch ein Computerprogramm auf einem marktüblichen Personal Computer bzw. Industrie PC, wenige Minuten.

Je größer der Anteil konstanter Tische KT1-KT4 in einer Bestücklinie BL ist, desto wichtiger wird eine gute Austaktung der Linie innerhalb der konstanten Tische KT1-KT4. Falls erforderlich, kann mit Hilfe eines Linebalancers die Austaktung der konstanten Tische KT1-KT4 verbessert werden.

Es kann vorkommen, dass es auf Grund der Problemstruktur nicht möglich ist, die vorgegebenen konstanten Tische zu rüsten, ohne z.B. aus Kapazitätsgründen die Machbarkeit eines oder mehrerer Lose bzw. Minimalcluster zu verlieren. In diesem Fall kann das Verfahren keine Lösung finden. Ein Hinweis an das aufrufende Programm, dass das Problem nicht lösbar ist, erfolgt in diesem Fall.

Das Konzept der konstanten Tische KT1-KT4 und das Verfahren zum Bestimmen von Rüstungen für konstante Tische KT1-KT4 ist unabhängig von der verwendeten Montagetechnik. So können die Bauelemente auf den Leiterplatten (Boards) in den Bestückautomaten mit Durchsteckmontagetechnik (Through-Hole Technology, kurz: THT), mit Oberflächenmontagetechnik (Surface-Mounting Technology, kurz: SMT)oder mit einer Hybridtechnik angebracht werden. Bei der Oberflächenmontagetechnik werden die Bauelemente flach auf das Substrat montiert und die elektrischen Anschlüsse mit den Leiterbahnen verbunden. Die flach auf der Oberfläche montierten Bauelemente werden als "Surface Mount Devices" (SMD) bezeichnet.

### Realisierung

Das erfindungsgemäße Verfahren zur Bestimmung von konstanten Tischen kann als Computerprogramm in einer gängigen Programmiersprache (z.B. C++, Java, etc.) implementiert werden und auf gängigen Computersystemen (z.B. Industrie PC, Workstation, etc.) mit Ein-/Ausgabeeinheiten, Prozessor und Speichereinheiten ausgeführt werden. Weiterhin ist es vorteilhaft, das erfindungsgemäße Verfahren als Softwareprogramm auf einem computerlesbaren Medium (Diskette, DVD, CD, USB-Stick, Memory Card usw.) abzuspeichern. Dadurch kann das erfindungsgemäße Verfahren sehr leicht als Produkt vertrieben werden. Prinzipiell kann dieses Produkt auch über das Internet verteilt bzw. vertrieben werden.

Verfahren zum Bestimmen von Rüstungen für konstante Tische von Bestückautomaten in Bestücklinien an fest vorgegebenen Tischlokationen mittels Gemischt Ganzzahliger Linearer Optimierung auf Basis von die Bestückinfrastruktur beschreibenden Eingabedaten und vom Bediener bzw. Benutzer vorgebbarer Eingabeparametern. Das Verfahren kann unabhängig von der verwendeten Montagetechnik (z.B. Durchsteckmontagetechnik, Oberflächenmontagetechnik oder einer Hybridtechnik) verwendet werden. Vorteilhaft ist das Verfahren einsetzbar, wenn darauf weitere Verfahren aufsetzen, wie z.B. Clusterverfahren zur Rüstfamilienbildung bzw. Line Balancing zur Taktzeitoptimierung.

## Patentansprüche

1. Verfahren zum Bestimmen von Rüstungen für konstante Tische (KT1-KT4) von Bestückautomaten (BA1,BA2) in Bestücklinien (BL) an fest vorgegebenen Tischlokationen, wobei die Rüstungen der konstanten Tische (KT1-KT4) in allen Rüstfamilien verwendet werden, wobei eine Rüstfamilie eine Menge von Losen umfasst, die innerhalb einer Rüstung gefertigt werden, **dadurch gekennzeichnet, dass**
die Rüstungen für die konstanten Tische (KT1-KT4) mittels Gemischt Ganzzahliger Linearer Optimierung auf Basis von Eingabedaten und Eingabeparametern berechnet werden.

2. Verfahren nach Anspruch 1,
**dadurch gekennzeichnet, dass**
als Eingabedaten für die Berechnung der Rüstungen folgende, die Bestückinfrastruktur (BL,BA1,BA2,TS,KT1-KT4,VT1-VT4,BK1-BK8) beschreibende, Daten verwendet werden:
- Tische mit Anzahl freier Spuren,
- Lokationen der konstanten Tische (KT1-KT4),
- Bauelemente mit Bestückpositionszahlen,
- Maximale Rüstanzahlen pro Bauelement,
- Mögliche Zuordnungen von Bauelementen zu Tischen,
- Spurbedarfe der Bauelemente auf den Tischen,
- Taktzeiten und Bestückpositionszahlen pro Bestückkopf (BK1-BK8) im Ergebnis ermittelt aus einer Einzellosoptimierung.

3. Verfahren nach Anspruch 2,
**dadurch gekennzeichnet, dass**
als weiteres, die Bestückinfrastruktur (BL,BA1,BA2,TS,KT1-KT4,VT1-VT4,BK1-BK8) beschreibendes, Eingabedatum für die Berechnung der Rüstungen eine minimale Taktzeitschranke vorgegeben wird.

4. Verfahren nach einem der vorstehenden Ansprüche,
**dadurch gekennzeichnet, dass**
als vom Benutzer vorgebbare Eingabeparameter für die Steuerung der Bestückung folgende Parameter verwendet werden:
- der maximale Füllgrad für die konstanten Tische (KT1-KT4);
- der maximale Füllgrad für variable Tische (VT1-VT4);
- maximale Anzahl erlaubter Erhöhungen der MaxSetupCounts;
- Optimierungsstrategie eines Bedieners.

5. Verfahren nach einem der vorstehenden Ansprüche, weiter umfassend folgenden Schritt:
Bestimmen von Rüstfamilien basierend auf den berechneten Rüstungen für die konstanten Tische (KT1-KT4).

6. Verfahren nach einem der vorstehenden Ansprüche, weiter umfassend folgenden Schritt:
Bestimmen der Rüstungen für die restlichen Tische in der Bestücklinie (BL) pro Rüstfamilie.

7. Computerprogramm-Produkt, welches auf einer Programm gesteuerten Einrichtung die Durchführung eines Verfahrens nach einem der Ansprüche 1 bis 6 veranlasst.

8. Computerlesbares Medium, umfassend Anweisungen, welche, wenn sie auf einem geeigneten Computer ausgeführt werden, den Computer dazu bringen, das Verfahren gemäß einem der Ansprüche 1 bis 6 auszuführen.

9. Bestückautomat (BA1,BA2), umfassend einen konstanten Tisch (KT1-KT4), wobei der Standort des konstanten Tisches (KT1-KT4) in einer Bestücklinie (BL) vorgegeben ist, wobei die Rüstungen des konstanten Tisches (KT1-KT4) in allen Rüstfamilien der Bestücklinie verwendet werden, wobei eine Rüstfamilie eine Menge von Losen umfasst, die innerhalb derselben Rüstung gefertigt werden, wobei die Rüstungen für den konstanten Tisch (KT1-KT4) gemäß einem Verfahren nach den Ansprüchen 1 bis 6 bestimmt sind.

## Claims

1. Method for determining fittings for constant tables (KT1-KT4) of automatic placement machines (BA1,BA2) in placement lines (BL) at predefined table locations, wherein the fittings of the constant tables (KT1-KT4) are used in all fitting groups, wherein a fitting group comprises a set of lots which are manufactured within a fitting, **characterised in that** the fittings for the constant tables (KT1-KT4) are calculated by means of mixed integer linear optimisation on the basis of input data and input parameters.

2. Method according to claim 1,
**characterised in that**
the following data describing the placement infrastructure (BL,BA1,BA2,TS,KT1-KT4,VT1-VT4,BK1-BK8) is used as the input data for the calculation of the fittings:
- tables with number of free tracks,
- locations of the constant tables (KT1-KT4),
- components with placement position numbers,
- maximum fitting numbers per component,
- possible associations of components with tables,
- track requirements of the components on the tables,
- cycle times and placement position numbers per placement head (BK1-BK8) in the result ascertained from a single lot optimisation.

3. Method according to claim 2,
**characterised in that**
a minimum cycle time limit is predefined as a further input data item, describing the placement infrastructure (BL,BA1,BA2,TS,KT1-KT4,VT1-VT4,BK1-BK8), for the calculation of the fittings.

4. Method according to one of the preceding claims, **characterised in that** the following parameters are used as input parameters which can be predefined by the user for controlling the placement:
- the maximum filling level for the constant tables (KT1-KT4);
- the maximum filling level for variable tables (VT1-VT4);
- maximum number of permitted increases in the MaxSetupCounts;
- optimisation strategy of a user.

5. Method according to one of the preceding claims, further comprising the following step:
Determination of fitting groups based on the calculated fittings for the constant tables (KT1-KT4).

6. Method according to one of the preceding claims, further comprising the following step:
Determination of the fittings for the remaining tables in the placement line (BL) for each fitting group.

7. Computer software product which causes a method according to one of claims 1 to 6 to be carried out on a program-controlled facility.

8. Computer-readable medium, comprising instructions which, when they are executed on a suitable computer, cause the computer to execute the method according to one of claims 1 to 6.

9. Automatic placement machine (BA1,BA2), comprising a constant table (KT1-KT4), wherein the location of the constant table (KT1-KT4) in a placement line (BL) is predefined, wherein the fittings of the constant table (KT1-KT4) are used in all the fitting groups of the placement line, wherein a fitting group comprises a set of lots which are manufactured within the same fitting, wherein the fittings for the constant table (KT1-KT4) are determined in accordance with a method according to claims 1 to 6.

## Revendications

1. Procédé de détermination d'équipements pour tables constantes (KT1-KT4) de machines de placement automatique (BA1, BA2) dans des chaînes de placement (BL) à des emplacements de tables prédéterminés de manière fixe, dans lequel les équipements des tables constantes (KT1-KT4) sont utilisés dans toutes les familles d'équipements, dans lequel une famille d'équipements comprend une quantité de lots qui sont préparés à l'intérieur d'un équipement,
**caractérisé en ce que**
les équipements pour les tables constantes (KT1-KT4) sont calculés au moyen d'une optimisation linéaire en nombres entiers mixtes sur la base de données d'entrée et de paramètres d'entrée.

2. Procédé selon la revendication 1,
**caractérisé en ce que**
les données suivantes, décrivant l'infrastructure de placement (BL, BA1, BA2, TS, KT1-KT4, VT1-VT4, BK1-BK8), sont utilisées en tant que données d'entrée pour le calcul des équipements :
- les tables avec le nombre de pistes libres,
- les emplacements des tables constantes (KT1-KT4),
- les éléments constitutifs ayant des nombres de positions de placement,
- les nombres d'équipements maximaux par élément constitutif,
- les associations possibles d'éléments constitutifs aux tables,
- les besoins en pistes des éléments constitutifs sur les tables,
- les temps de cycle et les nombres de positions de placement par tête de placement (BK1-BK8) dans le résultat défini à partir d'une optimisation des lots individuels.

3. Procédé selon la revendication 2,
**caractérisé en ce qu'**
en tant que donnée d'entrée supplémentaire décrivant l'infrastructure de placement (BL, BA1, BA2, TS, KT1-KT4, VT1-VT4, BK1-BK8) pour le calcul des équipements une limite minimale de temps de cycle est prédéterminée.

4. Procédé selon l'une des revendications précédentes, **caractérisé en ce que**
les paramètres suivants sont utilisés en tant que paramètres d'entrée pouvant être prédéterminés par l'utilisateur pour la commande du placement :
- le degré de remplissage maximal des tables constantes (KT1-KT4) ;
- le degré de remplissage maximal pour les tables variables (VT1-VT4) ;
- le nombre maximal d'augmentations autorisées du nombre maximal d'octets de paramétrage ;
- la stratégie d'optimisation d'un opérateur.

5. Procédé selon l'une des revendications précédentes, comprenant en outre l'étape suivante :
détermination des familles d'équipements sur la base des équipements calculés pour les tables constantes (KT1-KT4).

6. Procédé selon l'une des revendications précédentes, comprenant en outre l'étape suivante :
détermination des équipements pour les tables restantes dans la chaîne de placement (BL) par famille d'équipements.

7. Produit de programme informatique, qui induit la réalisation d'un procédé selon l'une des revendications 1 à 6 sur un dispositif commandé par un programme.

8. Support lisible sur ordinateur, comprenant des instructions qui, lorsqu'elles sont mises en oeuvre dans un ordinateur approprié, amènent l'ordinateur à réaliser le procédé selon l'une des revendications 1 à 6.

9. Machine de placement automatique (BA1, BA2), comprenant une table constante (KT1-KT4), dans laquelle l'emplacement de la table constante (KT1-KT4) dans une chaîne de placement (BL) est prédéterminé, dans laquelle les équipements de la table constante (KT1-KT4) sont utilisés dans toutes les familles d'équipement de la chaîne de placement, dans laquelle une famille d'équipements comprend une quantité de lots, qui sont préparés à l'intérieur du même équipement, dans laquelle les équipements pour la table constante (KT1-KT4) sont déterminés conformément à un procédé selon les revendications 1 à 6.
